(19) **Europäisches Patentamt / European Patent Office / Office européen des brevets**

(11) **EP 4 068 466 B1**

(12) **EUROPEAN PATENT SPECIFICATION**

(45) Date of publication and mention of the grant of the patent:
**15.05.2024 Bulletin 2024/20**

(21) Application number: **19951032.2**

(22) Date of filing: **31.10.2019**

(51) International Patent Classification (IPC):
**H01M 10/48** $^{(2006.01)}$     **H01M 10/42** $^{(2006.01)}$
**G01R 31/36** $^{(2020.01)}$     **G01R 31/367** $^{(2019.01)}$
**G01R 31/396** $^{(2019.01)}$     **G01R 31/385** $^{(2019.01)}$

(52) Cooperative Patent Classification (CPC):
**H01M 10/488; G01R 31/3865; H01M 10/425; H01M 10/4285; H01M 2200/00; Y02E 60/10**

(86) International application number:
**PCT/JP2019/042897**

(87) International publication number:
**WO 2021/084714 (06.05.2021 Gazette 2021/18)**

(54) **PROCESSING SYSTEM, MONITORING DEVICE, PROCESSING METHOD, MONITORING METHOD, AND PROGRAM**

VERARBEITUNGSSYSTEM, ÜBERWACHUNGSVORRICHTUNG, VERARBEITUNGSVERFAHREN, ÜBERWACHUNGSVERFAHREN UND PROGRAMM

SYSTÈME DE TRAITEMENT, DISPOSITIF DE SURVEILLANCE, PROCÉDÉ DE TRAITEMENT PROCÉDÉ DE SURVEILLANCE, ET PROGRAMME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.10.2022 Bulletin 2022/40**

(73) Proprietor: **InsuRTAP Inc.**
**Tokyo 107-0082 (JP)**

(72) Inventor: **KOSUGI, Shinichiro**
**Tokyo 107-0082 (JP)**

(74) Representative: **Betten & Resch**
**Patent- und Rechtsanwälte PartGmbB**
**Maximiliansplatz 14**
**80333 München (DE)**

(56) References cited:
| | |
|---|---|
| WO-A1-2006/009041 | WO-A1-2018/096969 |
| JP-A- 2008 076 295 | JP-A- 2018 156 739 |
| JP-A- 2019 164 959 | US-A1- 2019 293 720 |

**Description**

TECHNICAL FIELD

The present invention relates to a processing system, a monitoring apparatus, a processing method, a monitoring method, and a program.

BACKGROUND ART

Non-Patent Document 1 discloses a technology for enabling evaluation of a residual value by recognizing a state of health of a battery from a behavior at a time of charging.
WO 2018/09696 A1 discloses a technique for suppressing deterioration in the value of a power storage system. This invention provides a monitoring system comprising: a detection unit that detects that a detection value related to a power storage system satisfies a condition; a specifying unit that specifies the type of prohibited action executed in the power storage system that satisfies the condition; and a determination unit that, on the basis of the specified type of prohibited action, calculates the life of the power storage system and/or determines the time over which the power storage system can keep operating after the specification.

RELATED DOCUMENT

NON-PATENT DOCUMENT

[Non-Patent Document 1] Tomokazu Morita and 2 Others "Charging Curve Analysis Method to Visualize State of Health of Lithium-Ion Batteries through Internal State Estimation", [online], [searched on October 8, 2019], Internet <URL: https://www.toshiba.co.jp/tech/review/2013/10/68_10pdf/f07.pdf>

SUMMARY OF THE INVENTION

TECHNICAL PROBLEM

A power storage device when subjected to thermal runaway may cause a disaster such as burning by severely ejecting flame. Thus, a user has to use the power storage device while considering safety of the power storage device. However, a general user is not a professional acquainted with a structure and the like of the power storage device. Thus, for example, checking the safety of the power storage device is significantly burdensome for the user. For example, the burden of the user can be reduced by causing the power storage device to be certified safe by any institution skilled in the structure and the like of the power storage device.
Type approval that is granted for each type may be performed for certification of the safety of the power storage device. According to the type approval, a sense of security such that the power storage device is designed to be safe is obtained. However, the safety of the power storage device changes due to various factors that may change for each user, such as a way of use, an installation location, and the like. In the type approval that is granted based on design without considering the way of use, the installation location, and the like of each user, a sufficient sense of security cannot be provided with respect to the safety of the power storage device after use. Consequently, the burden of considering the safety of the power storage device for the user is significant.
An object of the present invention is to reduce a burden of considering safety of a power storage device for a user.

SOLUTION TO PROBLEM

The present invention is defined in the independent claims. The dependent claims define embodiments of the invention.

ADVANTAGEOUS EFFECTS OF INVENTION

According to the present invention, a burden of considering safety of a power storage device for a user is reduced.

BRIEF DESCRIPTION OF THE DRAWINGS

The above object and other objects, features, and advantages will become further apparent from a preferred embodiment described below and the following drawings appended thereto.

Fig. 1 is a diagram for describing a summary of a processing system of the present embodiment.
Fig. 2 is a diagram illustrating one example of a hardware configuration of the processing system of the present embodiment.
Fig. 3 is one example of a function block diagram of the processing system of the present embodiment.
Fig. 4 is a flowchart illustrating one example of a flow of process of the processing system of the present embodiment.
Fig. 5 is a diagram for describing one example of a process of the processing system of the present embodiment.
Fig. 6 is a diagram for describing one example of a process of the processing system of the present embodiment.

DESCRIPTION OF EMBODIMENTS

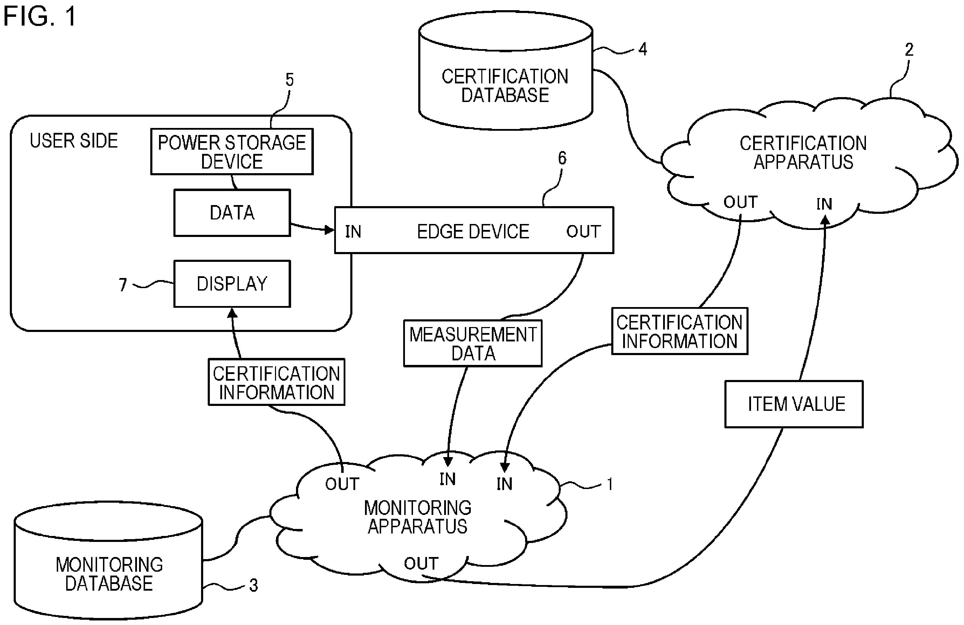

First, a summary of a processing system of the present embodiment will be described using Fig. 1. The processing system includes a monitoring apparatus 1 and a certification apparatus 2.

The monitoring apparatus 1 acquires measurement data indicating a state of a power storage device 5 from an edge device 6 installed on a user side and stores the measurement data in a monitoring database 3. The monitoring database 3 may store various information related to the power storage device 5 other than the measurement data. The monitoring apparatus 1 calculates an item value affecting safety of the power storage device 5 based on the measurement data and the like and transmits the calculated item value to the certification apparatus 2. The power storage device 5 is, for example, a storage battery.

The certification apparatus 2 determines the safety of the power storage device 5 based on the received item value and an evaluation reference stored in a certification database 4. In a case where the determined safety satisfies a predetermined condition, the certification apparatus 2 transmits (outputs) certification information certificating that the power storage device 5 is safe to the monitoring apparatus 1.

The monitoring apparatus 1 displays the received certification information on a display 7 installed on the user side.

In such a manner, the processing system of the present embodiment can determine the safety of the power storage device 5 based on the state of the power storage device 5 after a start of use, and certify the safety of the power storage device 5 based on the determination result. The processing system can display the certification information certifying that the power storage device 5 is safe on the display 7 on the user side. From the certification information displayed on the display 7, a user obtains a sense of security such that the power storage device 5 is in a safe state. Consequently, a burden of considering the safety of the power storage device 5 for the user is reduced.

Next, a configuration of the processing system will be described in detail. First, one example of a hardware configuration of the processing system will be described. Each function unit of the processing system is implemented by any combination of hardware and software mainly based on a central processing unit (CPU) of any computer, a memory, a program loaded in the memory, a storage unit (can store not only a program prestored from a step of shipping the apparatus but also a program downloaded from a storage medium such as a compact disc (CD) or a server or the like on the Internet) such as a hard disk storing the program, and an interface for network connection. Those skilled in the art may understand that various modification examples are present for the implementation method and the apparatus.

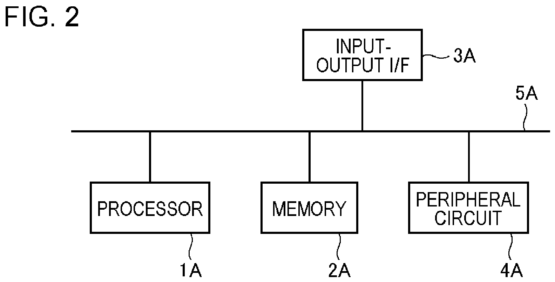

Fig. 2 is a block diagram illustrating a hardware configuration of the processing system. As illustrated in Fig. 2, the processing system includes a processor 1A, a memory 2A, an input-output interface 3A, a peripheral circuit 4A, and a bus 5A. The peripheral circuit 4A includes various modules. The processing system may not include the peripheral circuit 4A. The processing system may be configured with a plurality of physically and/or logically separated apparatuses or may be configured with one physically and/or logically integrated apparatus. In a case where the processing system is configured with the plurality of physically and/or logically separated apparatuses, each of the plurality of apparatuses can have the hardware configuration.

The bus 5A is a data transfer path for transmitting and receiving data among the processor 1A, the memory 2A, the peripheral circuit 4A, and the input-output interface 3A. The processor 1A is an operation processing device such as a CPU or a graphics processing unit (GPU). The memory 2A is a memory such as a random access memory (RAM) or a read only memory (ROM). The input-output interface 3A includes an interface for acquiring information from an input device, an external apparatus, an external server, an external sensor, a camera, or the like and an interface for outputting information to an output device, the external apparatus, the external server, or the like. The input device is, for example, a keyboard, a mouse, a microphone, a physical button, or a touch panel. The output device is, for example, a display, a speaker, a printer, or a mailer. The processor 1A can output an instruction to each module and perform operations based on the operation results of the modules.

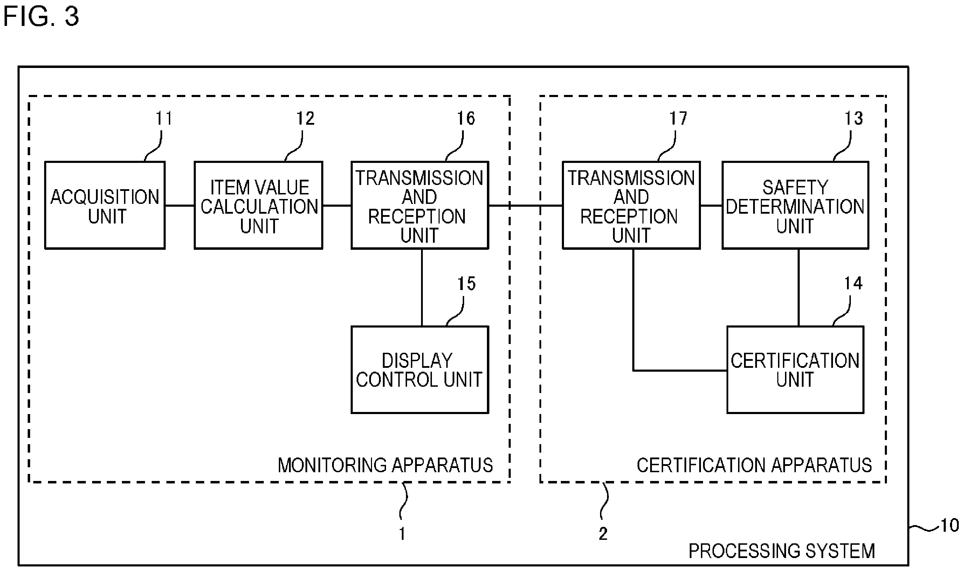

Next, a functional configuration of a processing system 10 will be described. Fig. 3 illustrates one example of a function block diagram of the processing system 10. As illustrated, the processing system 10 includes the monitoring apparatus 1 and the certification apparatus 2.

The monitoring apparatus 1 includes an acquisition unit 11, an item value calculation unit 12, a display control unit 15, and a transmission and reception unit 16. The certification apparatus 2 includes a safety determination unit 13, a certification unit 14, and a transmission and reception unit 17.

The acquisition unit 11 acquires the measurement data indicating the state of the power storage device 5 from the edge device 6. The acquisition unit 11 may further acquire identification information of the power storage device 5. The measurement data includes at least one of "operation mode", "state of charge (SOC)", "current", "cumulative charging and discharging amount", "cumulative charging and discharging power", "average values of cell voltage and temperature", "minimum values/maximum values of cell voltage and temperature and measurement position", "cell voltage, temperature, and reference voltage measurement value of a plurality of specific reference cells", "self-diagnosis result of battery management system (BMS)", "insulation resistance", and "device failure information". The measurement data may include other data. A method of measuring/acquiring the measurement data is not particularly limited and can employ any technology in the related art.

In the present specification, "acquisition" includes at least one of "causing a host apparatus to acquire data stored in another apparatus or a storage medium (active acquisition)" based on a user input or an instruction of a program, for example, reception by making a request or an inquiry to the other apparatus or accessing the other apparatus or the storage medium and reading, "inputting data output from the other apparatus into the host apparatus (passive acquisition)" based on the user input or the instruction of the program, for example, receiving distributed (or by transmission, push notification, or the like) data, or selective acquisition from the received data or information, and "generating new data by editing data (converting the data into a text, rearranging the data, extracting a part of the data, changing a file format, or the like) and acquiring the new data".

The item value calculation unit 12 calculates the item value affecting the safety of the power storage device 5 based on the measurement data acquired by the acquisition unit 11. The item value includes at least one of "operation time", "operation time in failure state/non-certified state", "cumulative charging and discharging amount", "low temperature cumulative charging and discharging amount", "high temperature cumulative charging and discharging amount", "capacity maintaining rate, positive electrode capacity, negative electrode capacity, extracted Li capacity, positive and negative electrode working voltages and SOC ranges, and value and variance of OCV deviation amount of average cell/reference cell", "voltage measurement error", "self-diagnosis result of BMS", "insulation resistance", and "device failure information". The item value may include other data. A method of calculating the item value from the measurement data is not particularly limited and can employ any technology in the related art.

The transmission and reception unit 16 transmits the item value calculated by the item value calculation unit 12 to the certification apparatus 2. The transmission and reception unit 17 receives the item value calculated by the item value calculation unit 12 from the monitoring apparatus 1. The transmission and reception unit 16 may further transmit the identification information of the power storage device 5 to the certification apparatus 2. The transmission and reception unit 17 may further receive the identification information of the power storage device 5 from the monitoring apparatus 1.

The safety determination unit 13 determines the safety of the power storage device 5 based on the calculated item value.

For example, for each item, a safety condition (example: the item value is greater than or equal to a reference value/less than or equal to the reference value) under which a determination indicating being safe can be made may be predetermined. In a case where an item value of a predetermined item does not satisfy the safety condition, the safety determination unit 13 may make a determination indicating "not being safe".

In addition, a plurality of items may be categorized into a plurality of groups. In a case where the number of items that are items belonging to a predetermined group and have item values not satisfying the safety condition is greater than or equal to a predetermined value, the safety determination unit 13 may make a determination indicating "not being safe". The predetermined value may be different for each group.

In a case where a condition under which a determination indicating "not being safe" is made is not satisfied, the safety determination unit 13 may make a determination indicating "being safe".

In addition, based on the calculated item value, the safety determination unit 13 may estimate a period (hereinafter, "safety maintaining period") in which a state where the safety satisfies the safety condition is maintained. For example, the safety determination unit 13 can calculate a trend (speed of change) of a change in item value based on a history of each item value and estimate the safety maintaining period (example: a period in which the item value is greater than or equal to the reference value/less than or equal to the reference value) based on the calculated trend and the current item value. That is, the safety determination unit 13 can estimate the safety maintaining period based on a change in item value over time. A method of calculating the safety maintaining period is not limited to this example. Hereinafter, a specific example of an operation process performed by the safety determination unit 13 will be described.

In a case where the safety determined by the safety determination unit 13 satisfies a predetermined condition (being "safe"), the certification unit 14 outputs the certification information certifying that the power storage device 5 is safe. The certification information is information configured using at least one of a text, a drawing, a photo, and a mark.

The certification unit 14 may output the safety maintaining period estimated by the safety determination unit 13 as an effective period of the certification information.

The transmission and reception unit 17 transmits the certification information to the monitoring apparatus 1. The transmission and reception unit 16 receives the certification information from the certification apparatus 2.

The display control unit 15 displays the certification information on the display 7 installed in accordance with the power storage device 5. For example, the display control unit 15 may display a mark certifying that the power storage device 5 is safe on the display 7 as the certification information. In addition, the display control unit 15 may display the safety maintaining period on the display 7 as the effective period of certification.

It is preferable that a correspondence relationship between the power storage device 5 and the display 7 is a relationship in which it can be recognized that the certification information displayed on the display 7 indicates the safety of the power storage device 5. For example, the power storage device 5 may include the display 7, or the display 7 may be installed around the power storage device 5.

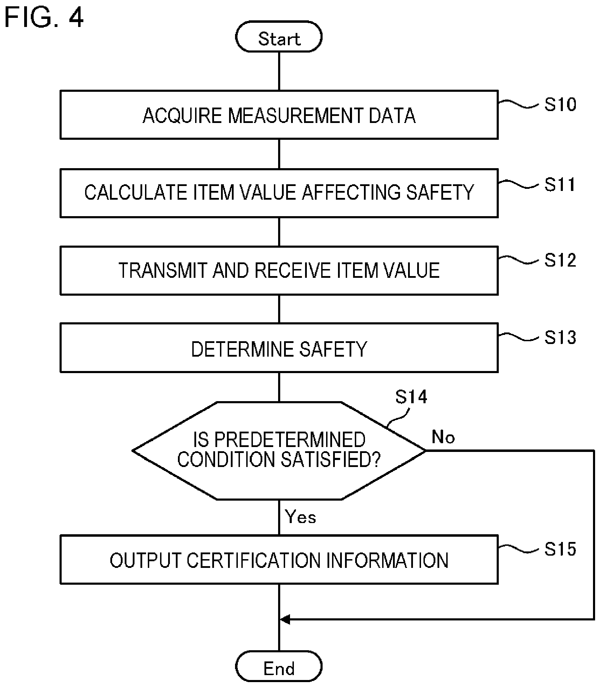

Next, one example of a flow of process of the processing system 10 will be described using the flowchart in Fig. 4.

First, the acquisition unit 11 acquires the measurement data indicating the state of the power storage device 5 from the edge device 6 (S10). There are various timings at which the acquisition unit 11 acquires the measurement data. For example, the acquisition unit 11 may acquire the measurement data at a predetermined time interval (example: every other month, every other week, every other day, every other 10 hours, or every other hour). In addition, the time interval may change in accordance with an elapsed time from a start timing of use of the power storage device 5. That is, as the elapsed time from the start timing of use is decreased, the time interval may be increased. In addition, the acquisition unit 11 may acquire the measurement data at a timing at which an instruction input from the user is provided.

Next, the item value calculation unit 12 calculates the item value affecting the safety of the power storage device 5 based on the measurement data acquired by the acquisition unit 11 (S11). There are various timings at which the item value calculation unit 12 calculates the item value. For example, each time the acquisition unit 11 acquires new measurement data, the item value calculation unit 12 may calculate the item value. In addition, the item value calculation unit 12 may calculate the item value at a predetermined time interval (example: every other month, every other week, every other day, every other 10 hours, or every other hour). In addition, the time interval may change in accordance with the elapsed time from the start timing of use of the power storage device 5. That is, as the elapsed time from the start timing of use is decreased, the time interval may be increased.

Next, the transmission and reception unit 16 of the monitoring apparatus 1 transmits the item value calculated in S11, and the transmission and reception unit 17 of the certification apparatus 2 receives the item value (S12). There are various timings at which the item value is transmitted and received. For example, each time the item value calculation unit 12 calculates a new item value, the transmission and reception unit 16 and the transmission and reception unit 17 may transmit and receive the item value. In addition, the transmission and reception unit 16 and the transmission and reception unit 17 may transmit and receive the item value at a predetermined time interval (example: every other month, every other week, every other day, every other 10 hours, or every other hour). In addition, the time interval may change in accordance with the elapsed time from the start timing of use of the power storage device 5. That is, as the elapsed time from the start timing of use is decreased, the time interval may be increased.

Next, the safety determination unit 13 determines the safety of the power storage device 5 based on the item value (S13). There are various timings at which the safety is determined. For example, each time a new item value is transmitted and received, the safety determination unit 13 may determine the safety. In addition, the safety determination unit 13 may determine the safety at a predetermined time interval (example: every other month, every other week, every other day, every other 10 hours, or every other hour). In addition, the time interval may change in accordance with the elapsed time from the start timing of use of the power storage device 5. That is, as the elapsed time from the start timing of use is decreased, the time interval may be increased.

Next, in a case where the safety determined in S13 satisfies the safety condition (Yes in S13), the certification unit 14 outputs the certification information certifying that the power storage device 5 is safe (S15). Then, the transmission and reception unit 17 of the certification apparatus 2 transmits the certification information, and the transmission and reception unit 16 of the monitoring apparatus 1 receives the certification information. The display control unit 15 displays the certification information on the display 7 installed in accordance with the power storage device 5.

In a case where the safety determined in S13 does not satisfy the safety condition (No in S13), the certification unit 14 does not output the certification information.

Next, one example of an operation process performed by the safety determination unit 13 will be described.

"Example 1"

Examples of a cause of capacity degradation (capacity decrease by use over years) of the power storage device 5 include "decrease in positive electrode capacity", "decrease in negative electrode capacity", and "decrease in metal ions due to deposition of metal (Li or the like) or the like". Regardless of which cause results in degradation, degradation causes a deviation from an originally designed state. Thus, operation voltage ranges of the positive electrode and the negative electrode change, and the safety of the power storage device 5 is impaired by deposition of metal or the like.

Therefore, in Example 1, the safety of the power storage device 5 and the safety maintaining period are estimated based on the capacity maintaining rate of the power storage device 5.

Specifically, the capacity maintaining rate (item value) is periodically (example: for every year) calculated and recorded. In a case where a safe use lower limit of the capacity maintaining rate of the power storage device 5 is P%, a determination indicating "being safe" can be made in a case where the calculated capacity maintaining rate is greater than or equal to P%, and a determination indicating "not being safe" can be made in a case where the calculated capacity maintaining rate is less than P%.

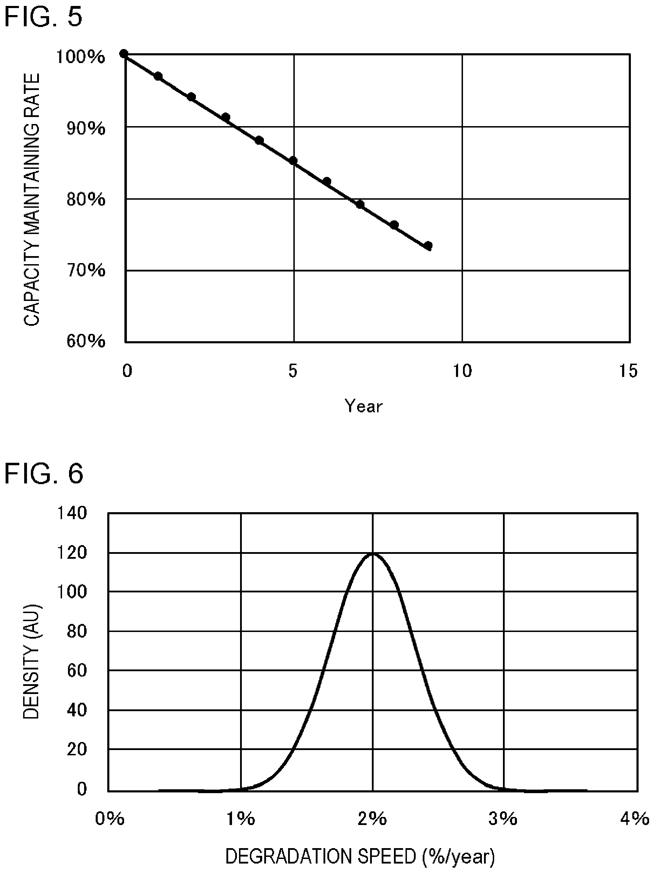

In addition, the safety maintaining period can be estimated based on a change in capacity maintaining rate over time. That is, a graph illustrated in Fig. 5 can be drawn with respect to the number of elapsed years or miles of use based on the past recording of the capacity maintaining rate. A trend (speed of change) of a change in capacity maintaining rate can be calculated from the illustrated graph. The safety maintaining period can be estimated based on the trend and the current capacity maintaining rate.

For example, it is assumed that the safe use lower limit of the capacity maintaining rate of the power storage device 5 is 70%. In a case of the example in Fig. 5, the capacity maintaining rate at a time of measurement in the ninth year is 73%, and annual average capacity degradation of past data is 3%. Thus, a period (safety maintaining period) until the capacity maintaining rate becomes 70% is calculated as one year.

The same process can be performed by employing a temperature at a time of output and input, an insulation resistance value, internal resistance of the power storage device 5, or the like instead of the capacity maintaining rate.

"Example 2"

As described in Example 1, the trend (speed of change) of the change in capacity maintaining rate is obtained by periodically calculating the capacity maintaining rate. A statistical distribution can be obtained by obtaining the speed of change for each power storage device 5 (refer to Fig. 6).

For the power storage device 5 that deviates from a normal degradation speed distribution by greater than or equal to a predetermined level and is degraded at a very high speed, certification indicating being safe is not granted. Meanwhile, for the power storage device 5 within a range of the normal degradation speed distribution, for example, determination of the safe and estimation of the safety maintaining period can be performed in accordance with the procedure in Example 1.

Instead of the degradation speed of the capacity maintaining rate, a distribution of a speed of increase in temperature at the time of output and input, a speed of decrease in insulation resistance value, a speed of increase in internal resistance of the battery, or the like can be used.

"Example 3"

A measurement result of a battery cell voltage can be decomposed into open circuit potentials (OCP) of the positive electrode and the negative electrode using, for example, the method disclosed in Non-Patent Document 1. Then, voltage ranges used by the positive electrode and the negative electrode and the SOC range, a non-operation Li amount, and the like of each of the positive electrode and the negative electrode can be found. In a case where the power storage device 5 is degraded, the positive electrode tends to be charged to a higher voltage even in a case where a charging voltage of the battery is the same. In a case where the voltage of the positive electrode is increased, it is known that the positive electrode becomes unstable and finally results in thermal runaway. The non-operation Li amount, the maximum voltage of the positive electrode, and capacities of the positive electrode and the negative electrode can be calculated, and these can be used as item values affecting the safety of the power storage device 5. The safety can be determined by determining whether or not the values of the item values satisfy the safety condition.

In addition, trends (speeds of change) of the item values can be obtained, and the safety maintaining period can be obtained based on the current item values and the trends (speeds of change).

For example, in a case where the battery cell voltage is measured at all times, and a plurality of reference cells to be observed over time are set in the system, more accurate determination can be expected. Probability density calculated from average values and standard deviations of the non-operation Li amount, the maximum voltage of the positive electrode, and the capacities of the positive electrode and the negative electrode for each of the reference cells can be used as a safety indicator. For example, in a case where the average value of the maximum voltage of the positive electrode in a specific battery system is 4.2 V, and the standard deviation thereof is 0.05 V, the maximum voltage of the positive electrode can be calculated as falling within $+3\sigma$, that is, 4.35 V, at a probability of 99% in the monitoring target system. In a case where the maximum voltage of the positive electrode of a safe use limit is 4.40 V, a determination indicating that the safety is still likely can be made.

"Example 4"

Chemical reactions inside the battery cell can also be described by the Arrhenius law. Thus, the safety of the battery can also be checked by an accelerated test. For example, in a case of the battery, the accelerated test under a condition of 75°C for 120 days corresponds to use at 25°C for 10 years. In addition, the accelerated test under a condition of 130°C for three days corresponds to use at 25°C for 12 years. In a case where a time (accelerated test time) for safe use without causing a failure or the like checked in the accelerated test is a safety limit time, for example, an estimate tsafe of the remaining time for safe use in an environment of room temperature (25°C: 298.15 K) can be calculated based on Expression (1) below.

$$tsafe = tt \exp(Ea(1/(298.15kb)-1/(Tt\,kb)) - \int \exp(Ea(1/(298.15kb)-1/(Ta\,kb))dt \quad \cdots \text{Expression (1)}$$

A definition of each variable is as follows.

tsafe: remaining time for safe use
tt: accelerated test time
Tt: accelerated test temperature (K)
t: elapsed time
Ta: actual use temperature (K)
Ea: activation energy
kb: Boltzmann constant

In addition, a remaining charging and discharging current integrated value Ah_safe for safe use can be calculated in the same manner. For example, calculation can be performed based on Expression (2) below.

$$Ah\_safe = Aht \exp(Ea(1/(298.15kb)-1/(Tt\,kb)) - \int A \exp(Ea(1/(298.14kb)-1/(Takb))dt \quad \cdots \text{Expression (2)}$$

Definitions of variables other than the above variables are as follows.

Ah_safe: remaining charging and discharging current integrated value (Ah) for safe use
Aht: charging and discharging current integrated value (Ah) for safe use that is checked in the accelerated test
A: current

"Example 5"

In a lithium-ion battery (LIB) cell, an operation called cell balance that uniforms the SOC between cells connected in series is necessary. A cell having fast self-discharging has a faster decrease in SOC and voltage than the others, and a cell having slow self-discharging has a high SOC and a high voltage. Thus, the SOC and the voltage can be uniformed by detecting a difference in voltage between the cells and discharging a cell having a high voltage (or conversely, charging a cell having a low voltage). For a cell having fast self-discharging, there is a possibility that any reaction, for example, a very small internal short circuit, has occurred inside the cell. In a case where a time-integrated value of a current caused to flow by the cell balance or a time in which charging or discharging is performed is measured, a history thereof is recorded, and a statistic thereof is acquired, a battery system or a module including an abnormal cell in an unsafe state can be detected even in a case where the user has used the battery system or the module without inconvenience. That is, in the battery system including the abnormal cell, a current integrated value consumed by the cell balance indicates a statistical abnormal value (example: greater than or equal to a predetermined value) or indicates a value significantly deviating from an average value (example: a difference between the value and the average value is at a predetermined position or further). Thus, safety certification can be cancelled when the abnormal value is indicated.

Next, a modification example of the processing system 10 of the present embodiment will be described. Up to this point, the processing system 10 has been configured with the plurality of physically and/or logically separated apparatuses (the monitoring apparatus 1 and the certification apparatus 2). However, the processing system 10 may be configured with physically and/or logically one apparatus. That is, physically and/or logically one apparatus may include the acquisition unit 11, the item value calculation unit 12, the safety determination unit 13, the certification unit 14, and the display control unit 15. In this case, the transmission and reception unit 16 and the transmission and reception unit 17 for transmitting and receiving information between two apparatuses are not necessary.

Next, an effect of the processing system 10 of the present embodiment will be described. The processing system 10 of the present embodiment can determine the safety of the power storage device 5 based on the state of the power storage device 5 after the start of use, and certify the safety of the power storage device 5 based on the determination result. The processing system 10 can display the certification information certifying that the power storage device 5 is safe on the display 7 on the user side.

According to the processing system 10, from the certification information displayed on the display 7, the user obtains a sense of security such that the power storage device 5 is in a safe state. Consequently, a burden of considering the safety of the power storage device 5 for the user is reduced.

In addition, according to the processing system 10, the period (safety maintaining period) in which the safety is maintained can be estimated, and the safety maintaining period can be displayed on the display 7 as the effective period of certification. According to the processing system 10, from the effective period displayed on the display 7, the user can recognize the estimation result of the period in which the safe state is maintained. Consequently, a burden of considering the safety of the power storage device 5 for the user is reduced.

**Claims**

1. A processing system comprising:

   an acquisition unit that acquires measurement data indicating a state of a power storage device;
   an item value calculation unit that calculates an item value affecting safety of the power storage device based on the measurement data;
   a safety determination unit that determines the safety of the power storage device based on the calculated item value; and
   a certification unit that outputs certification information certifying that the power storage device is safe, in a case where the determined safety satisfies a predetermined condition;
   wherein the safety determination unit estimates a period in which a state where the safety satisfies the predetermined condition is maintained, based on the calculated item value,
   wherein the certification unit outputs the period as an effective period of the certification information, and wherein the display control unit displays, as the certification information, a mark certifying that the power storage device is safe on a display, the display being included in the power storage device, or being installed around the power storage device.

2. The processing system according to claim 1,
   wherein the safety determination unit estimates the period based on a change in the item value over time.

3. The processing system according to claim 1 or 2, further comprising:
   a display control unit that displays the certification information on a display installed in accordance with the power storage device.

4. A processing method comprising:

   by a computer,
   acquiring measurement data indicating a state of a power storage device;
   calculating an item value affecting safety of the power storage device based on the measurement data;
   determining the safety of the power storage device based on the calculated item value; and
   outputting certification information certifying that the power storage device is safe, in a case where the determined safety satisfies a predetermined condition;
   in the determining the safety, estimating a period in which a state where the safety satisfies the predetermined condition is maintained, based on the calculated item value, and
   in the outputting certification information, outputting the period as an effective period of the certification information wherein the method comprises
   displaying, as the certification information, a mark certifying that the power storage device is safe on a display, the display being included in the power storage device, or being installed around the power storage device.

5. A computer program, which when being executed by a computer, causes said computer to carry out a method according to claim 4.

**Patentansprüche**

1. Ein Verarbeitungssystem, das Folgendes umfasst:

   eine Erfassungseinheit, die Messdaten erfasst, die einen Zustand einer Energiespeichervorrichtung anzeigen;
   eine Elementwert-Berechnungseinheit, die einen Elementwert, der die Sicherheit der Energiespeichervorrichtung beeinflusst, auf der Grundlage der Messdaten berechnet;
   eine Sicherheitsbestimmungseinheit, die die Sicherheit der Energiespeichervorrichtung basierend auf dem berechneten Elementwert bestimmt; und
   eine Zertifizierungseinheit, die Zertifizierungsinformationen ausgibt, die bestätigen, dass die Energiespeichervorrichtung sicher ist, wenn die bestimmte Sicherheit eine vorbestimmte Bedingung erfüllt;
   wobei die Sicherheitsbestimmungseinheit eine Zeitspanne schätzt, in der ein Zustand aufrechterhalten wird, in dem die Sicherheit die vorbestimmte Bedingung erfüllt, basierend auf dem berechneten Elementwert,
   wobei die Zertifizierungseinheit die Zeitspanne als eine effektive Zeitspanne der Zertifizierungsinformation ausgibt, und wobei
   die Anzeigesteuereinheit als die Zertifizierungsinformation eine Markierung, die bestätigt, dass die Energiespeichervorrichtung sicher ist, auf einer Anzeige anzeigt, wobei die Anzeige in der Energiespeichervorrichtung enthalten ist oder um die Energiespeichervorrichtung herum installiert ist.

2. Das Verarbeitungssystem nach Anspruch 1,
   wobei die Sicherheitsbestimmungseinheit die Zeitspanne auf der Grundlage einer Änderung des Elementwerts über die Zeit schätzt.

3. Das Verarbeitungssystem nach Anspruch 1 oder 2, ferner umfassend:
   eine Anzeigesteuereinheit, die die Zertifizierungsinformationen auf einer Anzeige anzeigt, die in Übereinstimmung mit der Energiespeichervorrichtung installiert ist.

4. Ein Verarbeitungsverfahren, das folgendes umfasst:

   durch einen Computer,
   Erfassen von Messdaten, die einen Zustand einer Energiespeichervorrichtung anzeigen;
   Berechnen eines die Sicherheit der Energiespeichervorrichtung beeinflussenden Elementwertes auf der Grundlage der Messdaten;
   Bestimmen der Sicherheit der Energiespeichervorrichtung basierend auf dem berechneten Elementwert; und
   Ausgeben von Zertifizierungsinformationen, die bescheinigen, dass die Energiespeichervorrichtung sicher ist, in einem Fall, in dem die bestimmte Sicherheit eine vorbestimmte Bedingung erfüllt;
   bei der Bestimmung der Sicherheit, Schätzen einer Zeitspanne, in der ein Zustand, in dem die Sicherheit die vorbestimmte Bedingung erfüllt, aufrechterhalten wird, basierend auf dem berechneten Elementwert, und
   bei der Ausgabe von Zertifizierungsinformationen, Ausgeben der Zeitspanne als eine effektive Zeitspanne der Zertifizierungsinformationen, wobei das Verfahren umfasst Anzeigen einer Markierung, die bestätigt, dass die Energiespeichervorrichtung sicher ist, als die Zertifizierungsinformation auf einer Anzeige, wobei die Anzeige in der Energiespeichervorrichtung enthalten ist oder um die Energiespeichervorrichtung herum installiert ist.

5. Computerprogramm, das, wenn es von einem Computer ausgeführt wird, den Computer veranlasst, ein Verfahren nach Anspruch 4 auszuführen.


**Revendications**

1. Un système de traitement comprenant :

   une unité d'acquisition qui acquiert des données de mesure indiquant un état d'un dispositif de stockage d'énergie ;
   une unité de calcul de valeur d'élément qui calcule une valeur d'élément affectant la sécurité du dispositif de stockage d'énergie sur la base des données de mesure ;
   une unité de détermination de sécurité qui détermine la sécurité du dispositif de stockage d'énergie sur la base de la valeur d'élément calculée ; et
   une unité de certification qui délivre des informations de certification certifiant que le dispositif de stockage d'énergie est sûr, dans le cas où la sécurité déterminée satisfait une condition prédéterminée ;
l'unité de détermination de sécurité estime une période pendant laquelle un état dans lequel la sécurité satisfait à la condition prédéterminée est maintenu, sur la base de la valeur d'élément calculée,
l'unité de certification délivre la période en tant que période effective des informations de certification, et
l'unité de commande d'affichage affichant, sur un écran, en tant qu'informations de certification, une marque certifiant que le dispositif de stockage d'énergie est sûr, l'affichage étant inclus dans le dispositif de stockage d'énergie, ou étant installé autour du dispositif de stockage d'énergie.

2. Le système de traitement selon la revendication 1,
dans lequel l'unité de détermination de sécurité estime la période sur la base d'un changement de la valeur de l'élément au fil du temps.

3. Le système de traitement selon la revendication 1 ou la revendication 2, comprenant en outre :
une unité de commande d'affichage qui affiche les informations de certification sur un écran installé conformément au dispositif de stockage d'énergie.

4. Un procédé de traitement comprenant :

par un ordinateur,
le fait d'acquérir des données de mesure indiquant un état d'un dispositif de stockage d'énergie ;
le fait de calculer une valeur d'élément affectant la sécurité du dispositif de stockage d'énergie sur la base des données de mesure ;
le fait de déterminer la sécurité du dispositif de stockage d'énergie sur la base de la valeur d'élément calculée ; et
le fait de délivrer des informations de certification certifiant que le dispositif de stockage d'énergie est sûr, dans le cas où la sécurité déterminée satisfait une condition prédéterminée ;
lors de la détermination de la sécurité, le fait d'estimer une période pendant laquelle un état dans lequel la sécurité satisfait à la condition prédéterminée est maintenu, sur la base de la valeur d'élément calculée, et
dans la délivrance d'informations de certification, le fait de délivrer la période en tant que période effective des informations de certification, le procédé comprenant
le fait d'afficher sur un écran, en tant qu'informations de certification, une marque certifiant que le dispositif de stockage d'énergie est sûr, l'écran étant inclus dans le dispositif de stockage d'énergie, ou étant installé autour du dispositif de stockage d'énergie.

5. Un programme informatique qui, lorsqu'il est exécuté par un ordinateur, amène ledit ordinateur à mettre en œuvre un procédé selon la revendication 4.

# FIG. 1

EP 4 068 466 B1

FIG. 2

FIG. 3

EP 4 068 466 B1

FIG. 4

```
        ┌─────────┐
        │  Start  │
        └─────────┘
             │
   ┌──────────────────────────────────┐
   │    ACQUIRE MEASUREMENT DATA       │─── S10
   └──────────────────────────────────┘
             │
   ┌──────────────────────────────────┐
   │ CALCULATE ITEM VALUE AFFECTING    │─── S11
   │            SAFETY                 │
   └──────────────────────────────────┘
             │
   ┌──────────────────────────────────┐
   │   TRANSMIT AND RECEIVE ITEM VALUE │─── S12
   └──────────────────────────────────┘
             │
   ┌──────────────────────────────────┐
   │        DETERMINE SAFETY           │─── S13
   └──────────────────────────────────┘
             │
          ╱─────────╲   S14
        ╱   IS PREDE-   ╲        No
       ╱   TERMINED       ╲──────────┐
       ╲ CONDITION SATIS- ╱          │
        ╲  FIED?        ╱            │
          ╲─────────╱               │
             │ Yes                   │
   ┌──────────────────────────────────┐  │
   │   OUTPUT CERTIFICATION INFORMATION│─── S15
   └──────────────────────────────────┘  │
             │◄─────────────────────────┘
        ┌─────────┐
        │   End   │
        └─────────┘
```

## FIG. 5

## FIG. 6

**EP 4 068 466 B1**

**REFERENCES CITED IN THE DESCRIPTION**

**Patent documents cited in the description**

- WO 201809696 A1

**Non-patent literature cited in the description**

- **TOMOKAZU MORITA.** *Charging Curve Analysis Method to Visualize State of Health of Lithium-Ion Batteries through Internal State Estimation,* 08 October 2019, https://www.toshiba.co.jp/tech/review/2013/10/68_10pdf/f07.pdf